# EUROPEAN PATENT APPLICATION

(11) **EP 4 475 360 A1**
(43) Date of publication of application: **11.12.2024**
(21) Application number: 23210786.2
(22) Date of filing: 20.11.2023
(51) Int. Cl.: H01S 5/0232, H01S 5/02326, H01S 5/02385, H01S 5/024

(54) **LASER CHIPS WITH A LEAD FRAME ATTACHMENT TO A PHOTONICS CHIP**

(30) Priority: 06.06.2023 US 202318206181
(71) Applicant: GlobalFoundries U.S. Inc., Malta, NY 12020 (US)
(72) Inventor: POZDER, Scott, Malta, NY, 12020 (US); FISHER, Daniel W., Malta, NY, 12020 (US); MALINOWSKI, John, Essex Junction, VT, 05452 (US)
(74) Representative: Lambacher, Michael

(57) **Abstract**

Structures including a photonics chip and a cavity-mounted laser chip, and methods of forming and using such structures. The structure comprises a photonics chip including a substrate and a cavity in the substrate. The structure further comprises a laser chip inside the cavity, and a lead frame comprising a first section attached to a portion of the laser chip and a second section attached to a portion of the photonics chip.

## Description

### BACKGROUND

This disclosure relates to photonics chips and, more specifically, to structures including a photonics chip and a cavity-mounted laser chip, and methods of forming and using such structures.

Photonics chips are used in many applications and systems including, but not limited to, data communication systems and data computation systems. A photonics chip includes a photonic integrated circuit comprised of optical components, such as modulators, polarizers, and optical couplers, that are used to manipulate light received from a light source. A laser chip may be integrated with the photonics chip and function as the light source. For example, a laser chip may be attached inside a cavity that is formed in a substrate of the photonics chip. The laser chip includes a semiconductor laser that is configured to emit light, such as coherent light at an infrared wavelength. Light emitted by the semiconductor laser may be supplied to an edge coupler, which is coupled to the photonic integrated circuit.

Aligning the semiconductor laser to the edge coupler during the attachment process can present technical challenges. The laser chip may be attached to the photonics chip by bump connections. The bump connections may include redistribution layers on the photonics chip and solder on the redistribution layers that is reflowed by a reflow process to provide the attachments between the laser chip and the photonics chip. The redistribution layers must be patterned in advance of the attachment process, which requires precise control over the patterning. In addition, the flow of the solder during the reflow process is another variable over which precise control should be exercised to form quality bump connections.

The precision of the alignment between the semiconductor laser and the edge coupler may be also limited by variations in the thickness of the laser chip, which introduces another variable into the alignment process. The semiconductor laser is unpowered during the alignment process, which also imposes a restriction because of an inability to rely on any type of active feedback.

Controlling the operating temperature of the semiconductor laser can also present technical challenges. The bump connections provide the primary conduction paths to sink heat generated during the operation of the laser chip, which imposes an inherent limitation on the ability to sink heat and control the operating temperature of the semiconductor laser.

Improved structures including a photonics chip and a cavity-mounted laser chip, and improved methods of forming and using such structures, are needed.

### SUMMARY

In an embodiment of the invention, a structure comprises a photonics chip including a substrate and a cavity in the substrate. The structure further comprises a laser chip inside the cavity, and a lead frame comprising a first section attached to a portion of the laser chip and a second section attached to a portion of the photonics chip.

The laser chip of the structure may include a first surface and a second surface opposite to the first surface; the first section of the lead frame may be attached to the first portion of the laser chip at the first surface; the cavity may include a bottom and a plurality of sidewalls that extend to the bottom, and the second surface of the laser chip may be adjacent to the bottom of the cavity. According to one variant, the second surface of the laser chip may abut the bottom of the cavity. According to another variant, the second surface of the laser chip may be spaced from the bottom of the cavity. Alternatively, the cavity may be a through hole that penetrates through the photonics chip.

Further, the laser chip may include a semiconductor laser with a light output; the photonics chip may include an edge coupler, and the cavity may have a depth that permits the light output to be aligned with the edge coupler.

The first portion of the laser chip may be a landing pad, and the structure may further comprise a plurality of interconnects extending from the landing pad to the first section of the lead frame. According to one variant, the laser chip may include a semiconductor laser, and the landing pad may be coupled to the semiconductor laser.

In addition to the above features, the first portion of the photonics chip may be a pad, and the structure may further comprise a solder joint configured to attach the second section of the lead frame to the pad of the photonics chip. Alternatively, the structure may further comprise an adhesive configured to attach the second section of the lead frame to the first portion of the photonics chip, and a wire attached by a wire bond to the second section of the lead frame.

In addition, the first section and the second section of the lead frame may be disposed outside of the cavity.

In addition, the lead frame of the structure may include a third section that is connected by a bend to the second section of the lead frame, and the second section of the lead frame may be disposed between the first section of the lead frame and the third section of the lead frame. Alternatively, the lead frame may include a third section connected by a bend to the first section of the lead frame.

In addition, the lead frame of the structure may include a third section attached to a second portion of the laser chip and a fourth section attached to a second portion of the photonics chip. Moreover, the laser chip may include a semiconductor laser; the first portion of the laser chip may be a first landing pad coupled to the semiconductor laser, and the second portion of the laser chip may be a second landing pad coupled to the semiconductor laser.

In an embodiment of the invention, a method comprises attaching a lead frame to a laser chip, gripping a first upright section of the lead frame with a pick and place tool, gripping a second upright section of the lead frame with the pick and place tool, and placing the laser chip into a cavity in a substrate of a photonics chip with the pick and place tool.

The method may further comprise energizing a semiconductor laser of the laser chip using the pick and place tool to emit light while the laser chip is inside the cavity.

Further, the method may further comprise aligning light emitted from the semiconductor laser of the laser chip with an edge coupler of the photonics chip using the pick and place tool while the semiconductor laser is energized.

Further, the method may further comprise attaching the lead frame to the photonics chip after the laser chip is inside the cavity.

In an embodiment of the invention, a method comprises forming a cavity in a substrate of a photonics chip, attaching a first section of a lead frame and a portion of a laser chip, and attaching a second section of the lead frame to a portion of the photonics chip. The laser chip is disposed inside the cavity when the second section of the lead frame is attached to the portion of the photonics chip.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals refer to like features in the various views.
FIG. 1 is a top view of a structure in accordance with embodiments of the invention.
FIG. 2 is a cross-sectional view taken generally along line 2-2 in FIG. 1.
FIG. 3 is a cross-sectional view in accordance with alternative embodiments of the invention.
FIG. 4 is a top view of a structure in accordance with alternative embodiments of the invention.
FIG. 5 is a cross-sectional view taken generally along line 5-5 in FIG. 4.
FIG. 5A is a cross-sectional view taken generally along line 5A-5A in FIG. 4.
FIG. 6 is a cross-sectional view of a structure in accordance with alternative embodiments of the invention.
FIG. 7 is a cross-sectional view of a structure in accordance with alternative embodiments of the invention.
FIG. 8 is a top view of a structure in accordance with alternative embodiments of the invention.
FIG. 9 is a top view of a structure in accordance with alternative embodiments of the invention.
FIG. 10 is a diagrammatic view of a pick and place tool in accordance with embodiments of the invention.

### DETAILED DESCRIPTION

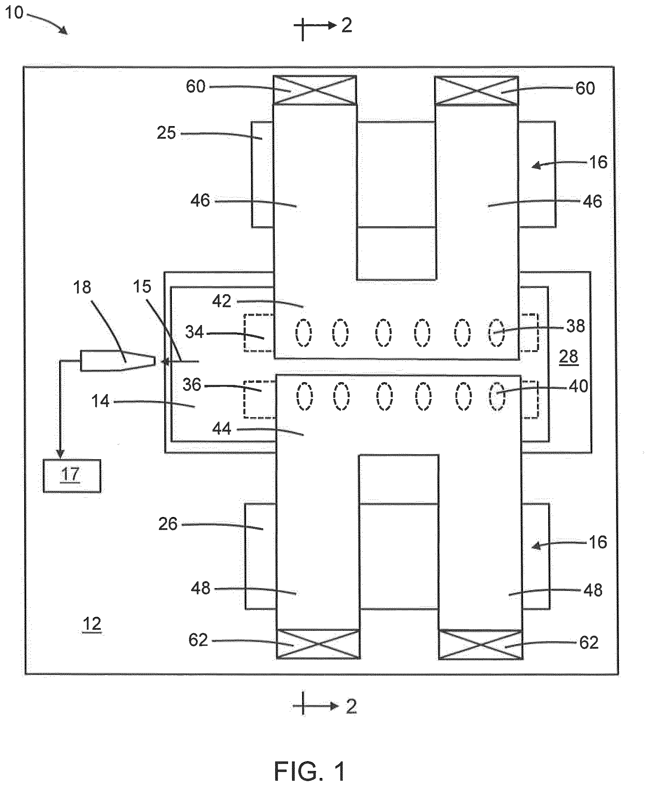

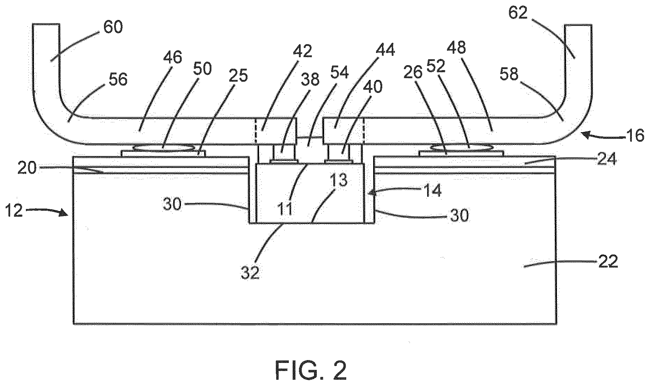

With reference to FIGS. 1, 2 and in accordance with embodiments of the invention, a structure 10 includes a photonics chip 12, a laser chip 14, and a lead frame 16 that are combined to form an assembly. The photonics chip 12 includes an edge coupler 18 that is positioned on, and over, a dielectric layer 20 and a semiconductor substrate 22. In an embodiment, the dielectric layer 20 may be comprised of a dielectric material, such as silicon dioxide, and the semiconductor substrate 22 may be comprised of a semiconductor material, such as single-crystal silicon. In an embodiment, the dielectric layer 20 may be a buried oxide layer of a silicon-on-insulator substrate, and the dielectric layer 20 may be positioned between the edge coupler 18 and the semiconductor substrate 22.

The edge coupler 18 may be comprised of a material having a refractive index that is greater than the refractive index of silicon dioxide. In an embodiment, the edge coupler 18 may be comprised of a semiconductor material, such as single-crystal silicon. In an alternative embodiment, the edge coupler 18 may be comprised of a dielectric material, such as silicon nitride, silicon oxynitride, or aluminum nitride. The edge coupler 18 may be formed by patterning a layer of its constituent material with lithography and etching processes. In an embodiment, the edge coupler 18 may be formed by patterning the semiconductor material (e.g., single-crystal silicon) of a device layer of a silicon-on-insulator substrate. In an embodiment, the edge coupler 18 may be formed by depositing a layer comprised of its constituent dielectric material (e.g., silicon nitride) and patterning the deposited layer with lithography and etching processes.

The edge coupler 18 may be configured to receive light of a given mode from the laser chip 14 and to route the light to a photonic integrated circuit 17 of the photonics chip 12. In an embodiment, the edge coupler 18 may include a tapered section having a narrow end defining a facet that is arranged proximate to a light output, which is diagrammatically indicated by the single-headed arrow 15, from which light is emitted by the laser chip 14.

The photonics chip 12 includes an interconnect structure 24 that may be formed by middle-of-line processing and back-end-of-line processing over the dielectric layer 20 and semiconductor substrate 22. The interconnect structure 24 may include multiple dielectric layers that are comprised of dielectric materials, such as silicon dioxide, silicon nitride, tetraethylorthosilicate silicon dioxide, or fluorinated-tetraethylorthosilicate silicon dioxide, and that are arranged in a layer stack on, and over, the dielectric layer 20 and the semiconductor substrate 22. The edge coupler 18 may be embedded in one or more of the dielectric layers of the interconnect structure 24. The interconnect structure 24 includes pads 25, 26 that may be comprised of a metal, such as aluminum, that may be coated by electroless nickel immersion gold or another type of under bump metallurgy.

The photonics chip 12 may include a cavity 28 that penetrates through the interconnect structure 24 and dielectric layer 20 into the semiconductor substrate 22. The cavity 28 includes sidewalls 30 and a bottom 32 surrounded by the sidewalls 30. The cavity 28 may be formed by one or more lithography and etching processes. The edge coupler 18 is positioned adjacent to one of the sidewalls 30 of the cavity 28. In an embodiment, the cavity 28 may penetrate partially through the semiconductor substrate 22. In an alternative embodiment, the cavity 28 may penetrate fully through the semiconductor substrate 22.

The laser chip 14 may be configured to emit light (e.g., laser light) of a given wavelength, intensity, mode shape, and mode size from the light output 15 that is coupled to the edge coupler 18. In an embodiment, the laser chip 14 may include a semiconductor laser comprised of one or more III-V compound semiconductor materials. In an embodiment, the laser chip 14 may include an indium phosphide/indium-gallium-arsenic phosphide laser that is configured to emit continuous laser light at an infrared wavelength. In an embodiment, the semiconductor laser of the laser chip 14 may include an active layer comprised of a semiconductor layer that emits light when biased and cladding layers that are comprised of semiconductor materials with bandgaps that are greater than the bandgap of the semiconductor material of the active layer.

The laser chip 14 is disposed inside the cavity 28. The shape and dimensions of the cavity 28 may be correlated with the shape and dimensions of the laser chip 14 such that the laser chip 14 can be inserted into the cavity 28. In that regard, the dimensions of the cavity 28 may be slightly greater than the dimensions of the laser chip 14 to provide clearance for insertion of the laser chip 14 into the cavity 28. The laser chip 14 includes a top surface 11 and a bottom surface 13 opposite from the top surface 11. The depth of the cavity 28 is chosen such that, after the laser chip 14 is placed into the cavity 28, the light output 15 of the laser chip 14 is aligned with the edge coupler 18 to provide an aligned state that promotes efficient light transfer. In an embodiment, the bottom surface 13 of the laser chip 14 may be disposed adjacent to the bottom 32 of the cavity 28 in the aligned state. In an embodiment, the bottom surface 13 of the laser chip 14 may abut the bottom 32 of the cavity 28 in the aligned state. In an embodiment, an optical adhesive may be applied in the space between the light output 15 of the laser chip 14 and the facet of the edge coupler 18, and then cured by, for example, ultraviolet light exposure.

The laser chip 14 may include laser landing pads 34, 36 providing interconnects that are coupled with the semiconductor laser of the laser chip 14. The laser landing pads 34, 36 may be comprised of a metal, such a nickel-gold alloy deposited by electroless plating process or a copper-nickel-gold alloy deposited by an electroplating process, that is patterned by lithography and etching processes after deposition. In an embodiment, the laser landing pads 34, 36 may be connected to n-type and p-type portions providing the cladding layers of the semiconductor laser of the laser chip 14.

Interconnects 38 are arranged in an array (e.g., one or more rows) on the laser landing pad 34, and interconnects 40 are also arranged in an array (e.g., one or more rows) on the laser landing pad 36. In an embodiment, the interconnects 38, 40 may be copper pillars deposited by a plating process and topped by solder. In an embodiment, the interconnects 38, 40 may be solder bumps. The interconnects 38, 40 may be used to attach the laser chip 14 to the lead frame 16.

The lead frame 16 may include die attach sections 42, 44, leads 46 defining cantilevered sections that project laterally from the die attach section 42, and leads 48 defining cantilevered sections that project laterally from the die attach section 44. The lead frame 16 may be formed by a stamping process or an etching process performed on a thin sheet comprised of a metal. In an embodiment, the metal of the lead frame 16 may be copper or a copper alloy. In an alternative embodiment, the metal may be a nickel-iron alloy that is magnetic and characterized by a low coefficient of thermal expansion. In an embodiment, the lead frame 16 may be used to power the semiconductor laser inside the laser chip 14 by connecting the die attach section 42 and leads 46 to power and by connecting the die attach section 44 and leads 48 to ground.

Each lead 46 of the lead frame 16 may be attached to the pad 25 of the photonics chip 12 by a solder joint 50 to provide a mechanical and electrical connection between the photonics chip 12 and the lead frame 16. The solder joints 50 may be formed by forming or placing solder balls on the pad 25 and reflowing the solder balls. Each lead 48 of the lead frame 16 may be attached to the pad 26 of the photonics chip 12 by a solder joint 52 to provide a mechanical and electrical connection between the photonics chip 12 and the lead frame 16. The solder joints 52 may be formed by forming or placing solder balls on the pad 26 and reflowing the solder balls.

The lead frame 16 is attached to the top surface 11 of the laser chip 14. In particular, the die attach section 42 of the lead frame 16 may be attached to the top surface 11 of the laser chip 14 by reflowed solder associated with the interconnects 38, and the die attach section 44 of the lead frame 16 may be attached to the top surface 11 of the laser chip 14 by reflowed solder associated with the interconnects 40 in order to provide mechanical and electrical connections between the laser chip 14 and the lead frame 16. The laser chip 14 is not connected to redistribution layers inside cavity 28, which are unnecessary because of the mechanical and electrical connections to the lead frame 16 at the top surface 11 of the laser chip 14. In an embodiment, the die attach sections 42, 44 of the lead frame 16 may be further attached to the laser chip 14 by a layer 54 of, for example, a no-flow underfill that encases the interconnects 38, 40 and provides mechanical reinforcement.

The lead frame 16 may function as a heat sink to remove heat generated by the laser chip 14 when powered, which may permit the operating temperature of the semiconductor laser to be lowered and/or may permit the output power to be increased. The lead frame 16 also offers a low thermal resistance path for heat transfer away from the laser chip 14, when powered, to the photonics chip 12.

The die attach sections 42, 44 and the leads 46, 48 of the lead frame 16 may be substantially flat or planar. In an embodiment, the lead frame 16 may include upright sections 60 defining tabs that project upwardly in a direction away from the photonics chip 12 and the laser chip 14, and each lead 48 of the lead frame 16 may include upright sections 62 defining tabs that project upwardly in a direction away from the photonics chip 12 and the laser chip 14. The leads 46 are disposed between the upright sections 60 and the die attach section 42, and a bend 56 connects each upright section 60 to the end of one of the leads 46. The upright sections 60 extend at an angle relative to a plane containing the die attach section 42 and the leads 46. In an embodiment, each lead 46 may be connected to the upright section 60 by a right-angle bend 56. The leads 48 are disposed between the upright sections 62 and the die attach section 44, and a bend 58 connects each upright section 62 to the end of one of the leads 48. The upright sections 62 extend at an angle relative to a plane containing the die attach section 44 and the leads 48. In an embodiment, each lead 48 may be connected to the upright section 62 by a right-angle bend 58.

The upright sections 60, 62 of the lead frame 16 may be utilized to insert the laser chip 14 into the cavity 28 in the semiconductor substrate 22 of the photonics chip 12 while the laser chip 14 is mechanically supported by the lead frame 16. For example, the upright sections 60, 62 may be gripped and maneuvered to insert the laser chip 14 into the cavity 28. The laser chip 14 is inverted when inserted into the cavity 28, which contrasts with conventional assembly approaches in which the laser chip 14 is non-inverted. Consequently, the depth of the cavity 28 is greater than conventional cavity depths for assembling laser and photonics chips. For example, the depth of the cavity 28 may be about 100 microns.

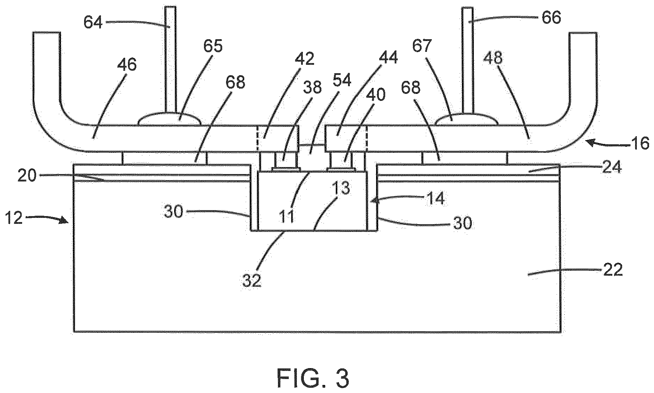

With reference to FIG. 3 and in accordance with alternative embodiments of the invention, one or more wires 64 may be attached by wire bonds 65 to the leads 46, and one or more wires 66 may be attached by wire bonds 67 to the leads 48. The wire bonds 65, 67 may be formed by a wire bonding process that relies on combination of downward pressure, ultrasonic energy, and optionally heat to attach the wires 64, 66 to the leads 46, 48. The wires 64, 66 may be comprised of a metal, such as gold or copper. The solder joints 50, 52 may be eliminated and replaced by an adhesive 68 that is configured to attach the leads 46, 48 of the lead frame 16 to the photonics chip 12.

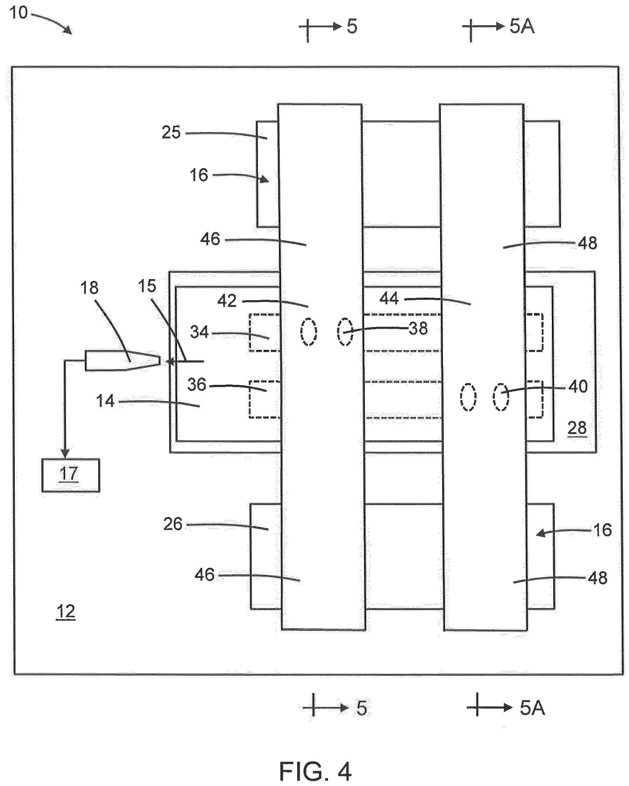

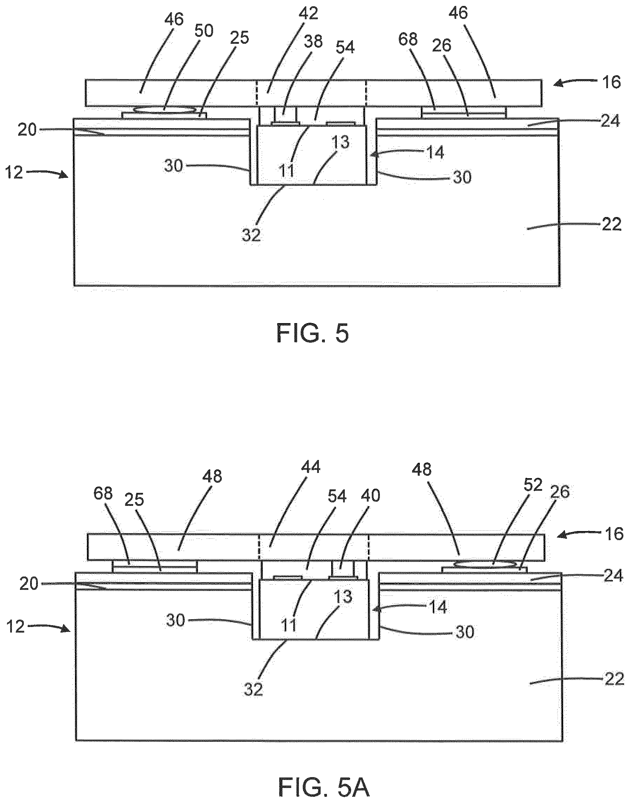

With reference to FIGS. 4, 5, 5A and in accordance with embodiments of the invention, the lead frame 16 may be modified such that the die attach section 42 and the leads 46 extend fully across portions of the cavity 28 and the laser chip 14, and the die attach section 44 and the leads 48 extend fully across different portions of the cavity 28 and the laser chip 14. In an embodiment, the upright sections 60, 62 may be omitted from the lead frame 16. The leads 46 are attached to the pad 25 by the solder joint 50 and to the pad 26 by the adhesive 68. The leads 48 are attached to the pad 25 by the adhesive 68 and to the pad 26 by the solder joint 52.

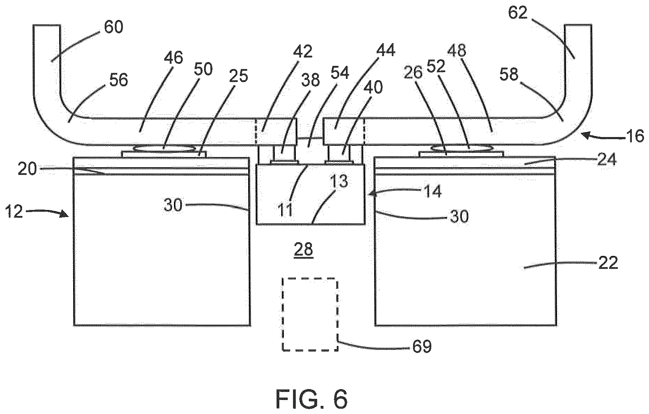

With reference to FIG. 6 and in accordance with embodiments of the invention, the cavity 28 may be extended to penetrate fully through the semiconductor substrate 22 of the photonics chip 12 as a through hole, and the lead frame 16 may suspend the laser chip 14 inside the cavity 28. Forming the cavity 28 as a through hole provides access for an alignment pin 69, which may be inserted from below the photonics chip 12 to contact the bottom surface 13 of the laser chip 14 and then used to assist with the process of aligning the light output 15 from the laser chip 14 with the edge coupler 18. Forming the cavity 28 as a through hole may also provide a thermal chimney for enhanced cooling of the laser chip 14 and/or permit the attachment of a thermal sink to the bottom surface 13 of the laser chip 14.

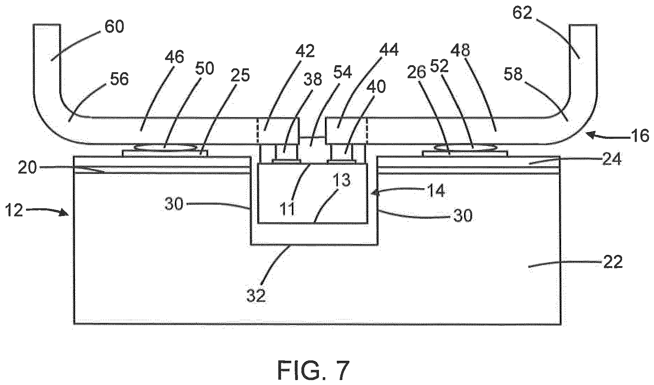

With reference to FIG. 7 and in accordance with embodiments of the invention, the depth of the cavity 28 in the semiconductor substrate 22 may be increased such the bottom surface 13 of the laser chip 14 is spaced from the bottom 32 of the cavity 28. Effectively, the cavity 28, which still extends partially through the semiconductor substrate 22, is deeper than the height of the laser chip 14 suspended from the lead frame 16 inside the cavity 28. The space between the bottom surface 13 of the laser chip 14 and the bottom 32 of the cavity 28 may enhance the thermal isolation or, alternatively, may be filled with an adhesive.

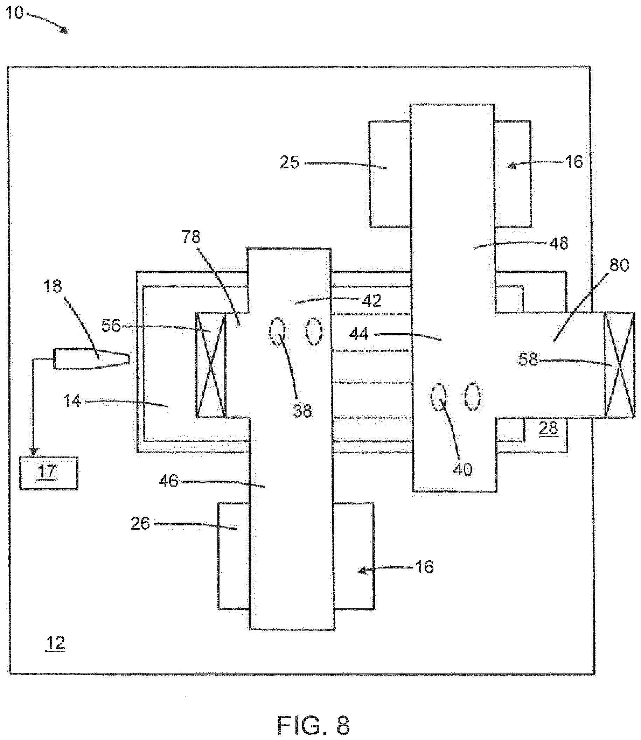

With reference to FIG. 8 and in accordance with embodiments of the invention, the lead frame 16 may be modified to add an extension section 78 that projects laterally from the die attach section 42 and an extension section 80 that projects laterally from the die attach section 44. The upright sections 60, 62 may be relocated from the leads 46, 48 of the lead frame 16 to the ends of the extension sections 78, 80.

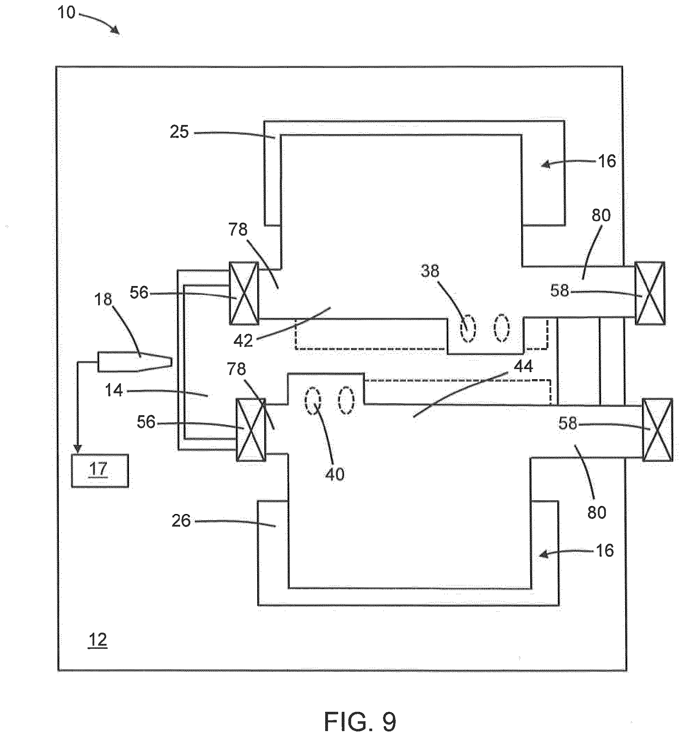

With reference to FIG. 9 and in accordance with embodiments of the invention, the lead frame 16 may be modified to add multiple extension sections 78, 80 that project laterally from the die attach section 42 and multiple extension sections 78, 80 that project laterally from the die attach section 44. The upright sections 60, 62 may be relocated from the leads 46, 48 to the ends of the extension sections 78, 80.

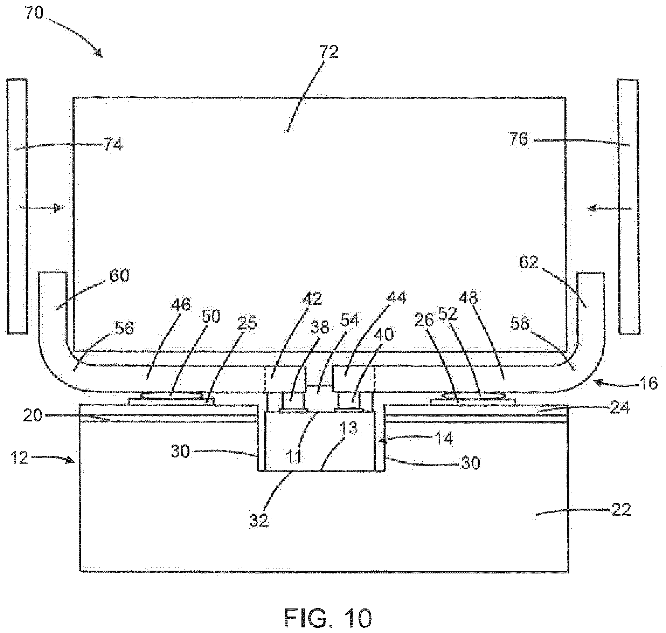

With reference to FIG. 10 and in accordance with embodiments of the invention, a pick and place tool 70 may include a pick block 72 and clamping arms 74, 76 that are positioned adjacent to the pick block 72. In an embodiment, the pick block 72 may be comprised of an electrical insulator, and the clamping arms 74, 76 may be comprised of a metal. The pick and place tool 70 may be configured to grip the upright sections 60, 62 of the lead frame 16 between the pick block 72 and the clamping arms 74, 76, and to manipulate the laser chip 14 and lead frame 16 to place the laser chip 14 into the cavity 28. In an embodiment, the clamping arms 74, 76 may be configured to power and energize the semiconductor laser inside the laser chip 14.

In use, the interconnects 38, 40 may be formed in respective arrays on the laser landing pads 34, 36 of the laser chip 14 at the wafer-level, and the laser chip 14 may then be singulated by dicing. The interconnects 38, 40 may be driven into and through the layer 54 of no-flow underfill to establish contact with the laser landing pads 34, 36. Portions of the laser landing pads 34, 36 of the laser chip 14 contacting the interconnects 38, 40 may be attached to the lead frame 16 by reflowing the solder associated with the interconnects 38, 40 to form the bumped connections. The lead frame 16 mechanically supports the laser chip 14 by the bumped connections, and the bumped connections electrically couple the lead frame 16 to the semiconductor laser of the laser chip 14. After the lead frame 16 is attached to the laser chip 14, the lead frame 16 may be trimmed, and the upright sections 60, 62 may be formed.

The pick and place tool 70 may be used to pick the laser chip 14 by gripping the upright section 60 of the lead frame 16 between the pick block 72 and the clamping arm 74, and by gripping the upright section 62 of the lead frame 16 between the pick block 72 and the clamping arm 76. These releasable connections provide an interface that enables the pick and place tool 70 to move and maneuver the gripped lead frame 16 and laser chip 14 relative to the photonics chip 12. In particular, the laser chip 14 may be placed by the pick and place tool 70 into the cavity 28 in the photonics chip 12 while being supported from the gripped upright sections 60, 62 of the lead frame 16. The lead frame 16 may be disposed fully outside of the cavity 28, and the bumped side of the laser chip 14 including the interconnects 38, 40 may be disposed adjacent to the lead frame 16.

The solder joints 50, 52 may be formed by reflowing solder to provide the electrical and mechanical connections between the pads 25, 26 of the photonics chip 12 and the lead frame 16. In an alternative embodiment, the mechanical connections may be established between the photonics chip 12 and the lead frame 16 using the adhesive 68, followed by the formation of the wires 64, 66 that are attached by the wire bonds 65, 67 to the lead frame 16. In an embodiment, the leads 46, 48 may be bent before the laser chip is inserted into the cavity 28 and the solder joints 50, 52 are formed by solder reflow. An optical adhesive may be applied in the space between the light output 15 of the laser chip 14 and the facet of the edge coupler 18, and then cured by, for example, ultraviolet light exposure.

In an embodiment, the laser chip 14 may be powered while disposed inside the cavity 28, which enables active alignment of the light output 15 with the facet of the edge coupler 18. In an embodiment, the clamping arms 74, 76 may be configured to power and energize the semiconductor laser of the laser chip 14 through the bumped connections between the lead frame 16 and the laser chip 14 before the solder joints 50, 52 are formed, which enables active alignment of the light output 15 to the facet of the edge coupler 18. The light output 15 may be aligned with the edge coupler 18 by bending the leads 46, 48 of the lead frame 16. In an embodiment, the leads 46, 48 may be bent after the laser chip 14 is inserted into the cavity 28 and before the solder joints 50, 52 are formed by solder reflow. In an embodiment, the leads 46, 48 may be bent after the laser chip 14 is inserted into the cavity 28 and while the solder joints 50, 52 are being formed by solder reflow. In an embodiment, the leads 46, 48 may be bent after the laser chip 14 is inserted into the cavity 28 and after the solder joints 50, 52 are formed by solder reflow.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate a range of +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction in the frame of reference perpendicular to the horizontal, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features may "overlap" if a feature extends over, and covers a part of, another feature with either direct contact or indirect contact.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a photonics chip including a substrate and a cavity in the substrate;
a laser chip inside the cavity; and
a lead frame comprising a first section attached to a first portion of the laser chip and a second section attached to a first portion of the photonics chip.

2. The structure of claim 1 wherein the laser chip includes a first surface and a second surface opposite to the first surface, the first section of the lead frame is attached to the first portion of the laser chip at the first surface, the cavity includes a bottom and a plurality of sidewalls that extend to the bottom, and the second surface of the laser chip is adjacent to the bottom of the cavity.

3. The structure of claim 2 wherein the second surface of the laser chip abuts the bottom of the cavity, or wherein the second surface of the laser chip is spaced from the bottom of the cavity.

4. The structure of claim 1 wherein the cavity is a through hole that penetrates through the photonics chip.

5. The structure of one of claims 1 to 4 wherein the first portion of the laser chip is a landing pad, and further comprising:
a plurality of interconnects extending from the landing pad to the first section of the lead frame, and, optionally, wherein the laser chip includes a semiconductor laser, and the landing pad is coupled to the semiconductor laser.

6. The structure of one of claims 1 to 5 wherein the laser chip includes a semiconductor laser with a light output, the photonics chip includes an edge coupler, and the cavity has a depth that permits the light output to be aligned with the edge coupler.

7. The structure of one of claims 1 to 6 wherein the first portion of the photonics chip is a pad, and further comprising:
a solder joint configured to attach the second section of the lead frame to the pad of the photonics chip.

8. The structure of one of claims 1 to 6 further comprising:
an adhesive configured to attach the second section of the lead frame to the first portion of the photonics chip; and
a wire attached by a wire bond to the second section of the lead frame.

9. The structure of one of claims 1 to 8 wherein the first section and the second section of the lead frame are disposed outside of the cavity.

10. The structure of one of claims 1 to 9 wherein the lead frame includes a third section connected by a bend to the first section of the lead frame, or wherein the lead frame includes a third section that is connected by a bend to the second section of the lead frame, and the second section of the lead frame is disposed between the first section of the lead frame and the third section of the lead frame.

11. The structure of one of claims 1 to 9 wherein the lead frame includes third section attached to a second portion of the laser chip and a fourth section attached to a second portion of the photonics chip, and, optionally, wherein the laser chip includes a semiconductor laser, the first portion of the laser chip is a first landing pad coupled to the semiconductor laser, and the second portion of the laser chip is a second landing pad coupled to the semiconductor laser.

12. A method comprising:
attaching a lead frame to a laser chip;
gripping a first upright section of the lead frame with a pick and place tool;
gripping a second upright section of the lead frame with the pick and place tool; and
placing the laser chip inside a cavity in a substrate of a photonics chip with the pick and place tool.

13. The method of claim 12 further comprising:
energizing a semiconductor laser of the laser chip using the pick and place tool to emit light while the laser chip is inside the cavity; and.
aligning light emitted from the semiconductor laser of the laser chip with an edge coupler of the photonics chip using the pick and place tool while the semiconductor laser is energized.

14. The method of claim 12 or claim 13 further comprising:
attaching the lead frame to the photonics chip after the laser chip is inside the cavity.

15. A method comprising:
forming a cavity in a substrate of a photonics chip;
attaching a first section of a lead frame and a portion of a laser chip; and
attaching a second section of the lead frame to a portion of the photonics chip,
wherein the laser chip is disposed inside the cavity when the second section of the lead frame is attached to the portion of the photonics chip.
